Europäisches Patentamt

European Patent Office

Office européen des brevets

(11) Numéro de publication : **0 326 467 B1**

(12) **FASCICULE DE BREVET EUROPEEN**

(45) Date de publication du fascicule du brevet :
**11.11.92 Bulletin 92/46**

(51) Int. Cl.$^5$ : **G02F 1/135, H04N 5/238**

(21) Numéro de dépôt : **89400172.6**

(22) Date de dépôt : **20.01.89**

(54) **Obturateur sélectif de lumière, procédé de réalisation, et son application à un détecteur d'image.**

(30) Priorité : **22.01.88 FR 8800683**

(43) Date de publication de la demande :
**02.08.89 Bulletin 89/31**

(45) Mention de la délivrance du brevet :
**11.11.92 Bulletin 92/46**

(84) Etats contractants désignés :
**DE GB NL**

(56) Documents cités :
**EP-A- 0 141 012**
**EP-A- 0 178 190**
**EP-A- 0 179 915**
**GB-A- 2 164 759**
**US-A- 4 538 884**
**APPLIED OPTICS, vol 20, no. 8, 15 avril 1981,**
**pages 1424-1432, Optical Society of America,**
**New York, US ; R.A. ATHALE et al. :"Bistability**
**and tresholding by a new photoconductor-**
**twisted nematic liquid crystal device with opti-**
**cal feedback"**

(73) Titulaire : **THOMSON-CSF**
**51, Esplanade du Général de Gaulle**
**F-92800 Puteaux (FR)**

(72) Inventeur : **Hepp, Bernard**
**THOMSON-CSF SCPI 19, avenue de Messine**
**F-75008 Paris (FR)**
Inventeur : **Mourey, Bruno**
**THOMSON-CSF SCPI 19, avenue de Messine**
**F-75008 Paris (FR)**
Inventeur : **Le Pesant, Jean-Pierre**
**THOMSON-CSF SCPI 19, avenue de Messine**
**F-75008 Paris (FR)**

(74) Mandataire : **Grynwald, Albert et al**
**THOMSON-CSF SCPI**
**F-92045 PARIS LA DEFENSE CEDEX 67 (FR)**

EP 0 326 467 B1

**Description**

L'invention concerne un obturateur sélectif de lumière et notamment un dispositif limitant l'éblouissement d'un détecteur d'image. L'invention concerne également un procédé de réalisation de cet obturateur et son application à un détecteur d'image tel que caméra de télévision du type vidicon ainsi qu'à un dispositif de détection à transfert de charge (CCD).

Dans le domaine de la prise de vue d'image lumineuse, deux problèmes de suréclairement ou d'éblouissement peuvent apparaître:

- L'intensité moyenne de l'image à capter est supérieure à celle admise par le détecteur d'image. Dans ce cas un diaphragme mécanique ou une densité optique peuvent être placés dans le trajet optique et limiter le flux lumineux moyen arrivant sur le détecteur d'image.

- La dynamique en intensité de l'image à capter est supérieure à celle du détecteur d'image. C'est le cas par exemple pour les caméras à bas niveaux de lumière (B.N.L.) faites pour travailler dans un environnement nocturne et qui reçoivent tout à coup, dans leur champ, l'image d'un phare d'automobile. C'est le cas aussi pour les caméras TV utilisées dans les retransmissions sportives lorsqu'elles passent d'une zone d'ombre à une zone ensoleillée dans un stade.

Dans les deux cas le détecteur d'image est ébloui, la dynamique de l'image à restituer devenant trop importante.

Il n'existe pas actuellement de dispositif simple permettant de diminuer localement et de façon contrôlée, l'intensité lumineuse de certaines zones d'image, afin de diminuer ce phénomène d'éblouissement.

La demande de brevet français N° 86 11728 ainsi que le document "Bistability and Thresholding by a new photoconductor-twisted nematic liquid crystal device with optical feedback" de R.A. ATHALE et al, publié dans la revue Applied Optics, volume 20, N° 8, du 15 avril 1981, pages 1424 à 1432, décrivent des valves optiques à cristal liquide commandées par effet photoconducteurs. Cependant ces valves optiques ne permettent pas d'obtenir une dynamique de réponse suffisante.

Selon l'invention, on prévoit donc un dispositif fournissant une grande dynamique de réponse pour être utilisable dans différents systèmes tel que caméra de télévision ou dans les intensificateurs d'images radiologiques.

L'invention concerne donc un obturateur sélectif de lumière comportant une première lame et une deuxième lame transparente enserrant un matériau électrooptique, la deuxième lame transparente portant sur sa face, en contact avec le matériau électrooptique, au moins une contre-électrode de commande ; la première lame portant sur sa face en contact avec le matériau électrooptique une pluralité d'électrodes image, au moins une électrode de commande, des éléments en matériau photoconducteur dont la résistance varie avec l'éclairement qu'il reçoit et permettant de coupler chacune une électrode image à l'électrode de commande, les électrode image étant arrangées sous forme matricielle ; caractérisé en ce que chaque élément en matériau photoconducteur encadre une électrode image et est en contact d'une part avec une électrode image et, d'autre part, avec l'électrode de commande.

L'invention concerne également un procédé de réalisation d'un obturateur sélectif selon la revendication 15.

Enfin l'invention concerne également un détecteur d'images appliquant l'obturateur sélectif précédant, comprenant un système optique d'entrée et une surface photosensible et qui comporte donc également un obturateur sélectif situé entre le système optique d'entrée et la surface photosensible, les deux lames de l'obturateur étant en matériau transparent ainsi que les électrodes image et les contre-électrodes.

Les différents objets et caractéristiques de l'invention apparaîtront plus clairement dans la description qui va suivre faite à titre d'exemple en se reportant aux figures annexées qui représentent:

- la figure 1, une vue de dessus d'un exemple de réalisation d'un obturateur selon l'invention;
- la figure 2, une vue en coupe de l'obturateur de la figure 1;
- la figure 3, un schéma électrique équivalent de l'obturateur selon l'invention;
- la figure 4, l'obturateur de la figure 2 équipé de polariseurs;
- la figure 5, une courbe de fonctionnement d'un exemple de réalisation selon l'invention;
- les figures 6 et 7, un obturateur selon l'art connu;
- la figure 8, une autre variante de réalisation de l'obturateur de l'invention;
- les figures 9 à 13, différentes étapes du procédé de réalisation selon l'invention d'un obturateur sélectif:
- la figure 14, un exemple d'application d'un obturateur selon l'invention;
- la figure 15, une variante d'application d'un obturateur selon l'invention appliquée à un détecteur à transfert de charges;
- la figure 16, une courbe contraste-tension pour un cristal liquide utilisé en biréfringence.

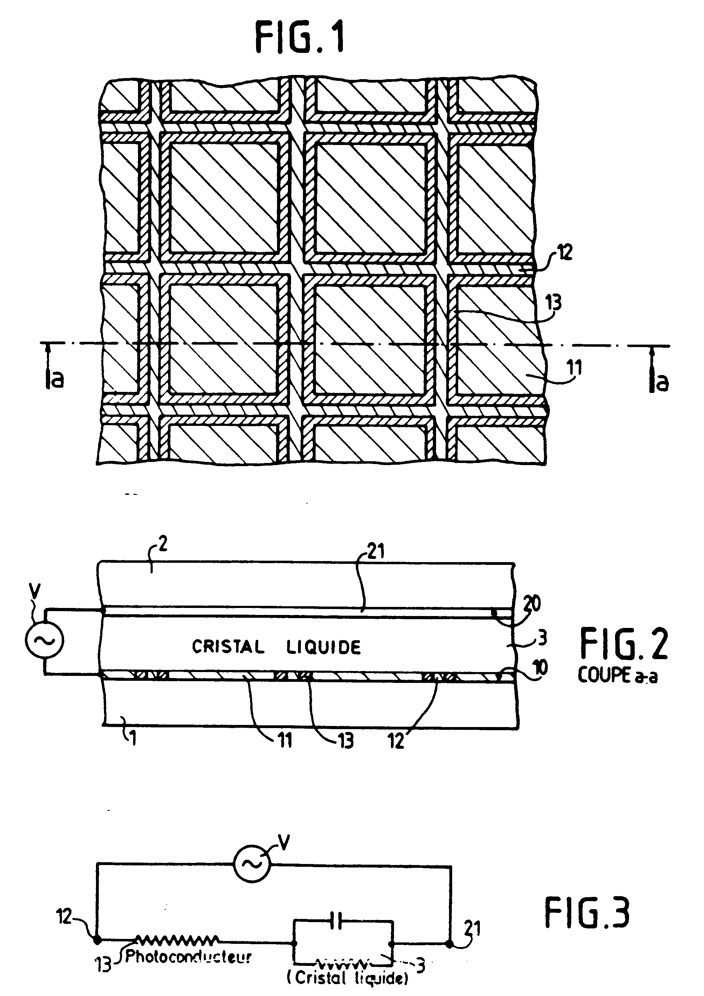

Les figures 1 et 2 représentent un exemple de réalisation de l'obturateur optique selon l'invention.

Il comporte, comme cela est visible en figure 2, deux lames 1 et 2 enserrant un cristal liquide 3. La face 10 de la lame 1 en contact avec le cristal liquide 3 comporte des électrodes image 11 (pixels). Chaque électrode image est entourée par un élément en matériau photoconducteur 13. Ces éléments photoconducteurs sont en contact avec au moins une électrode de commande 12.

Sur l'exemple de réalisation de la figure 1, l'électrode de commande 12 est réalisée sous forme d'un quadrillage. Dans chaque maille du quadrillage est contenue une électrode image 11 et le contact entre l'électrode image 11 et l'électrode de commande 12 est réalisée par le matériau photoconducteur 13 qui entoure l'électrode image 11.

Sur la face 20 de la lame 2 est prévue une contre-électrode 21.

Enfin, un générateur de tension V permet d'appliquer une différence de potentiel entre l'électrode de commande 12 et la contre-électrode 21.

La figure 3 représente un schéma électrique équivalent du dispositif ainsi réalisé. On a ainsi connecté en série aux bornes du générateur V:

- l'électrode de commande 12;
- le matériau photoconducteur 13;
- le cristal liquide 3 représenté par une résistance et un condensateur en parallèle;
- la contre-électrode 21.

Le matériau photoconducteur 13 est choisi de façon à ce que sa résistance varie en fonction de la lumière qu'il reçoit.

Notamment, il est choisi de telle façon que sa résistance diminue lorsque son éclairement augmente. Dans ce cas, si l'éclairement du photoconducteur augmente, sa résistance diminue, et la tension du générateur V se reporte sur le cristal liquide ce qui a pour effect de modifier le comportement du cristal liquide et donc ces propriétés de transmission de la lumière.

En affectant un élément de matériau photoconducteur 13 à chaque électrode image 11 on réalise ainsi un ensemble d'obturateurs, chaque obturateur réagissant individuellement en fonction de la lumière qu'il reçoit. C'est ainsi qu'un obturateur peut recevoir un éclairement important et limiter la transmission de lumière tandis qu'un obturateur voisin peut recevoir moins de lumière et avoir un comportement différent.

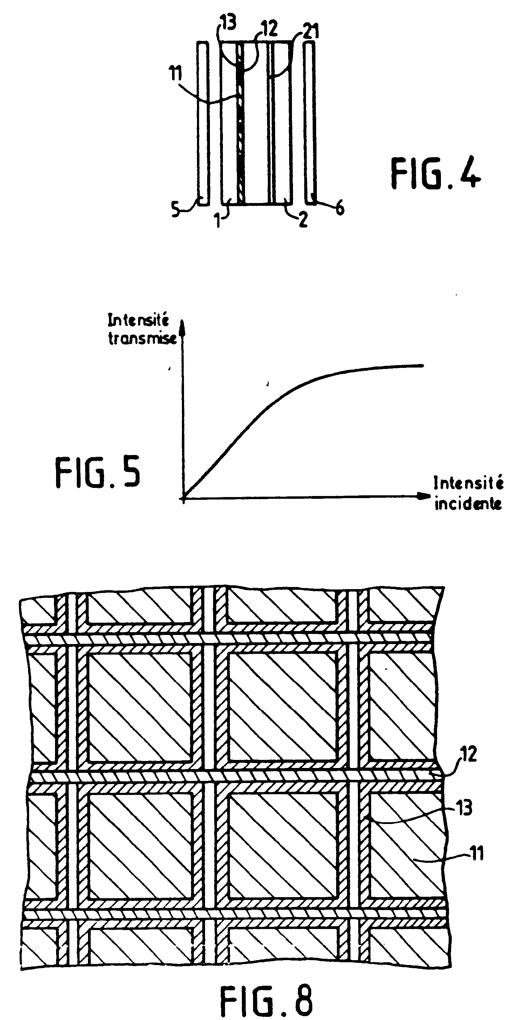

Le dispositif des figures 1 et 2 lorsqu'il fonctionne en transmission a ses deux lames 1 et 2 transparentes ainsi que les électrodes image 11 et la contre-électrode 21. On associe alors aux deux faces du dispositif deux polariseurs 5 et 6 comme cel est représenté en figure 4.

Dans le cas ou le cristal liquide 3 est du type nématique en hélice, les deux polariseurs 5 et 6 ont leurs axes de polarisation perpendiculaires, ces deux polariseurs sont indispensables avec l'effet électrooptique nématique en hélice.

Une tension électrique alternative est appliquée aux bornes du dispositif (entre la contre-électrode et l'électrode de commande).

Dans l'obscurité ou sous faible éclairement lumineux, la résistance du photoconducteur est grande et la tension d'alimentation du dispositif se reporte sur celui-ci. Elle est donc très faible sur l'élément d'image et donc sur le cristal liquide.

Sous éclairement plus important, la résistance du photoconducteur diminue, la tension d'alimentation se reporte alors sur le cristal liquide qui commute donc. L'effet électrooptique du cristal a pour effet de diminuer l'intensité lumineuse transmise dans une zone de l'image où celle-ci est trop importante.

La figure 5 donne une courbe de l'intensité transmise par ce dispositif en fonction de l'intensité incidente. On note qu'en dessous d'une certaine valeur de l'intensité incidente, l'intensité transmise est directement proportionelle à l'intensité incidente, au-dessus de cette valeur, l'intensité transmise présente une saturation.

Les différents paramètres de la valve optique (épaisseur de la cellule, type de cristal liquide, type d'effet électro-optique, épaisseur du photoconducteur, épaisseur, forme...) peuvent être ajustés, afin d'obtenir la courbe intensité transmise en fonction de l'intensité incidente qui répond le mieux aux besoins de l'application, en particulier au niveau de la sensibilité du dispositif. Enfin, la valve optique étant séparée en éléments d'image, la diminution locale de l'intensité lumineuse transmise ne peut s'effectuer que sur une surface au moins égale à celle de l'élément d'image. On voit donc que le nombre d'éléments d'image, ou le pas de la structure, dépend de la finesse avec laquelle on veut éviter l'éblouissement.

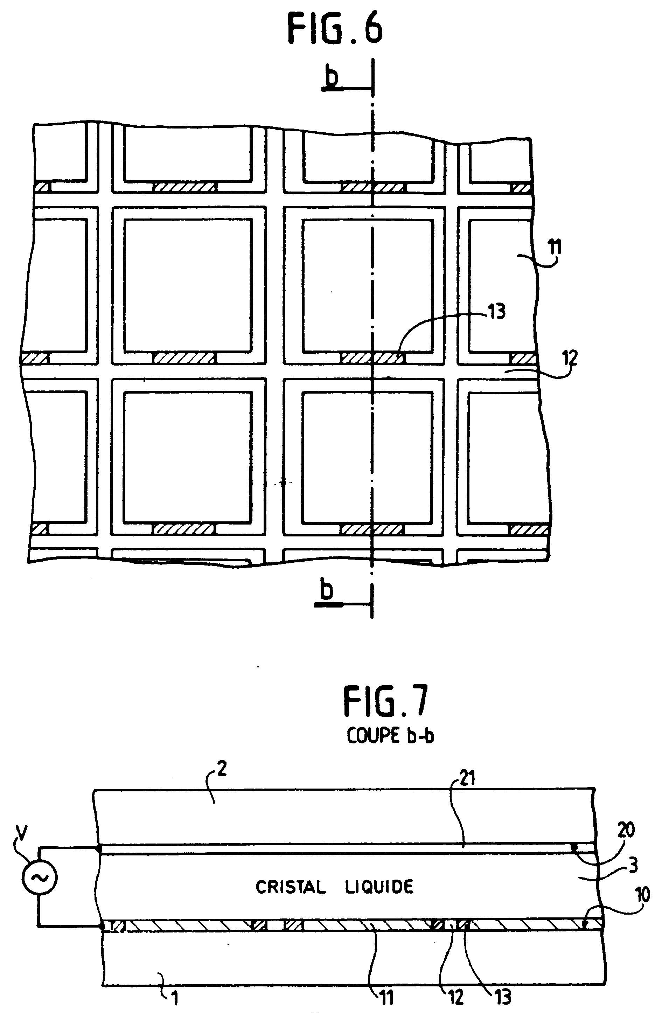

Les figures 6 et 7 représentent un obturateur selon l'art connu. Dans cet obturateur, les éléments en matériau photoconducteur 13 n'entourent pas les électrodes images 11. Par exemple, ils sont réalisés sous forme de plots. Dans ce cas en fonctionnement en transmission la lumière traverse l'obturateur entre les électrodes images puisque, contrairement au dispositif des figures 1 et 2 il n'y a pas autour des électrodes images, du matériau photoconducteur arrêtant la transmission de la lumière. La variante de réalisation des figures 6 et 7 prévoit donc sur la face 20 de la lame 2, des rubans 22 opaques à la transmission de la lumière dans les zones correspondant aux zones de la face 10 de la lame 1 non occupées par les électrodes images 11. A titre d'exemple, ces rubans opaques 22 sont réalisés directement sur la face 20 et la contre-électrode 21 recouvre l'ensemble. Mais selon une autre variante de réalisation, les rubans opaques 22 peuvent être réalisés sur la contre-électrode 21.

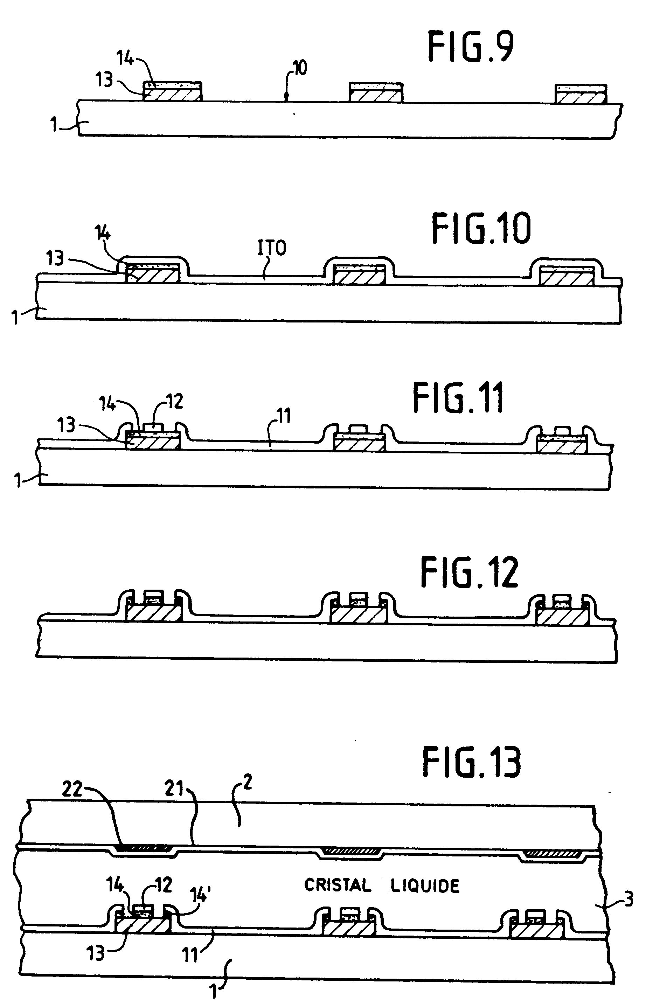

Selon une autre variante de réalisation, applicable à l'exemple de réalisation des figures 1 et 2 aussi bien qu'à celui des figures 6 et 7, l'électrode de commande 12 au lieu d'être réalisé sous forme d'un quadrillage est réalisé sous forme de plusieurs électrodes 12. Par exemple, en appliquant cette variante à l'obturateur des figures 1 et 2, comme cela est représenté sur la figure 8, l'obturateur possède alors plusieurs électrodes de commande lignes 12.

En se reportant aux figures 9 à 13 on va maintenant décrire un exemple de procédé de réalisation selon l'invention.

Au cours d'une première étape on dépose sur une lame de verre 1 une couche d'un matériau photoconducteur telle qu'une couche mince de silicium amorphe hydrogéné (a-Si : H). Par exemple, l'épaisseur de cette couche sera de 0,1 à 1 micromètre d'épaisseur. Avant ce dépôt, la lame de verre est éventuellement recouverte d'une couche d'un matériau, tel que de la silice, servant de couche d'arrêt de la gravure ou de barrière de diffusion des impuretés entre le verre et le matériau photoconducteur.

Au cours d'une deuxième étape, on dépose sur la couche précédente,une couche mince de silicium amorphe hydrogéné dopé au phosphore (a-Si H($n^+$)) d'environ 0,005 à 0,05 micromètre d'épaisseur. Cette couche est nécessaire pour assurer un bon contact ohmique entre l'ITO et le photoconducteur. Ces dépôts sont réalisés par la méthode dite C.V.D. (Chemical Vapor Deposition) assistée plasma.

Lors d'une troisième étape ces deux couches sont alors gravées par un procédé photolithographique classique pour former un quadrillage. On obtient ainsi sur la face 10 de la lame 1 (figure 9) des éléments photoconducteurs 13 recouvert d'une couche de contact 14.

Ensuite lors d'une quatrième étape on dépose une couche mince conductrice et transparente telle qu'une couche mince d'oxyde mixte d'indium et d'étain (I.T.O.). On obtient ainsi une structure représentée en figure 10.

Lors d'une cinquième étape cette couche est ensuite gravée pour former les électrodes image et l'électrode de commande du dispositif. Sur la figure 11, on voit donc ces électrodes images 11 et ces électrodes de commande 12.

Enfin ce dépôt d'ITO est utilisé durant une sixième étape, comme masque pour graver par un procédé de gravure sèche classique, la couche 14 de silicium amorphe hydrogéné dopé $n^+$ (a-Si : H$n^+$). Ainsi, le contact électrique entre électrode de commande et éléments d'images ne se fait plus qu'à travers la couche photoconductrice 13 de silicium amorphe hydrogéné a-Si : H. On obtient la structure de la figure 12.

Sur la contre lame, un dépôt 22 d'un matériau opaque, par exemple un dépôt métallique de chrome, est réalisé et gravé suivant une géométrie identique à celle de l'élément photoconducteur. Ce réseau métallique servira de masque optique pour le dispositif et permet d'augmenter le contraste de celui-ci. En effet, dans la surface définie par ce masque, le cristal liquide n'est pas commandé par le photoconducteur. En masquant cette zone, toute la lumière transmise par le dispositif est contrôlée par le photoconducteur et toute zone non utilisée est noire. Ce dépôt 22 de matériau opaque n'est cependant par indispensable si la couche de matériau photoconducteur est présente partout où le cristal liquide n'est pas commandé par le pixel. En effet, dans ce cas, le matériau photoconducteur, qui est opaque, fait lui-même office de masque de lumière.

Une couche mince d'ITO est enfin déposée sur ce réseau métallique 22 et forme la contre-électrode du dispositif.

La suite de la technologie est identique à celle des afficheurs à cristaux liquides. Les deux lames sont assemblées et sont scellées en enserrant un cristal liquide 3 (voir figure 13).

Si on utilise l'effet électrooptique nématique en hélice, on déposera, sur les faces intérieures des deux substrats, une couche mince de polyimide servant de couche d'orientation du cristal liquide.

Ce polyimide sera frotté dans deux directions perpendiculaires pour chaque substrat. L'intervalle entre les deux lames de verre, contrôlé par des cales d'épaisseur du type fibre de verre ou bille de plastique, sera ensuite rempli par le cristal liquide. Enfin, deux polariseurs seront placés de chaque côté de la cellule dans des positions croisées l'une par rapport à l'autre.

Selon une autre variante de réalisation de l'invention et dans certaines conditions, le contact entre les électrodes images 11 et les électrodes de commande 12 d'une part et la couche 13 d'autre part a-Si : H($n^+$) peut être instable (vieillisement dû à une réduction de l'ITO). Dans ce cas on pourra intercaller une couche métallique (Cr, Mo, etc.) entre ces deux couches et ce sans complication technologique.

Dans ces conditions, au cours des deux premières étapes précédentes la lame 1 est recouverte de silicium amorphe (a-Si : H), de silicium amorphe dopé au phosphore (a-Si - H,$n^+$) et d'une couche métallique (Cr, Mo, etc.). Les trois couches sont alors gravées par un procédé photolithographique classique pour former un quadrillage.

Une couche mince conductrice transparente (ex. : ITO) est ensuite déposée et gravée comme précédemment. Ce dépôt d'ITO est alors utilisé comme masque pour graver la couche métallique et la couche de a-Si : H($n^+$).

A l'issue de cette étape, la couche métallique n'existe plus qu'entre l'ITO et a-Si H ($N^+$) et évite de ce fait une interaction entre ces deux matériaux.

La suite de la réalisation est identique à celle décrite précédemment.

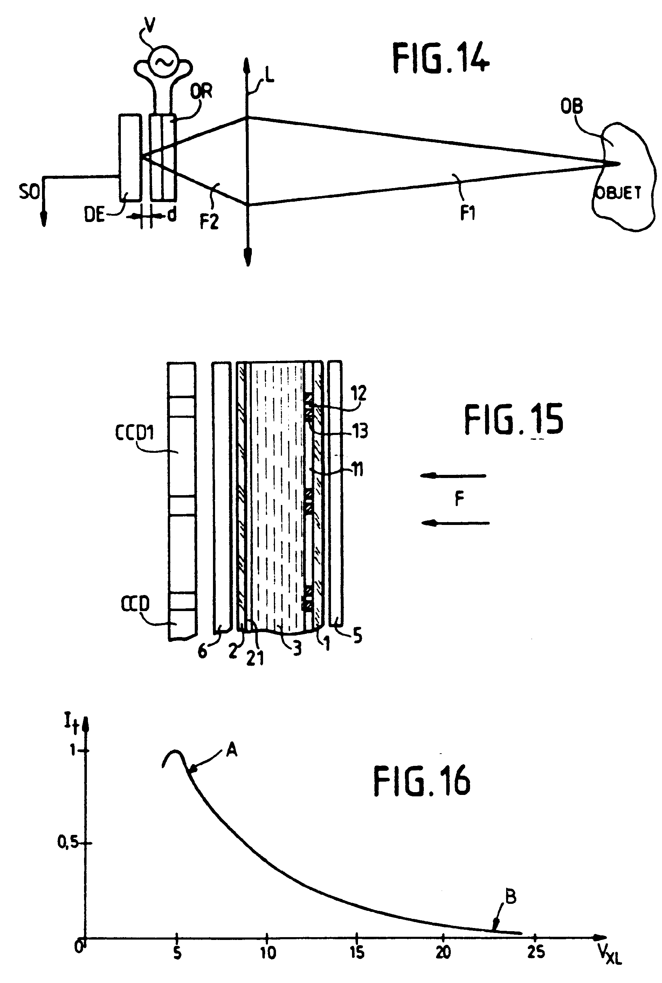

La figure 14 représente un exemple d'application de l'obturateur de l'invention à un détecteur d'images tel qu'un système de prise de vues (caméra de prise de vues).

Dans un système de prise de vue classique on trouve le détecteur d'image DE (dispositif à transfert de charge ou tube de prise de vue), l'objectif L permettant de faire l'image d'un objet OB sur le détecteur d'image DE et un diaphragme non représenté limitant, si nécessaire, le flux lumineux moyen sur le détecteur.

Dans le cadre de l'invention, l'obturateur OR est utilisé comme système anti-éblouissement et doit être placé entre l'objet OB et le détecteur d'image proche du plan image final ou d'un plan image intermédiaire. Dans l'exemple que nous avons pris, l'obturateur ou dispositif anti-éblouissement est placé à une distance d du détecteur d'image entre l'objectif L et le détecteur DE.

Si le détecteur d'image est un tube de prise de vue type Vidicon, pour ne pas voir apparaître sur l'image final le réseau métallique, il faudra défocaliser légèrement le dispositif. Une valeur typique, dépendant de la focale et de l'ouverture pourra être par exemple de d = 10.

Si le détecteur d'image comporte un dispositif à transfert de charges (CCD) on peut choisir pour le dispositif un pas égal ou multiple du pas du CCD et appliquer le dispositif le plus près possible du senseur d'image (d≈O). On s'affranchit ainsi du réseau métallique noir.

Plus précisément, les détecteurs à transfert de charges ayant des dimensions déterminées et étant généralement arrangés sous forme d'une matrice dont les lignes et colonnes possèdent un pas déterminé. L'obturateur sera conçu de telle façon que le électrodes images aient les mêmes dimensions que les détecteurs à transfert de charges et soient arrangés de la même façon. L'obturateur se superpose ainsi au dispositif de détection DE. De cette façon, on évite un effet de moiré lorsque l'obturateur sélectif fonctionne.

La figure 15 représente de façon simplifiée un tel arrangement.

On retrouve sur cette figure l'obturateur avec cec deux lames 1 et 2 portant les électrodes images 11, électrodes de commande 12, éléments photoconducteur 13 ainsi que la contre-électrode 21. Les polariseurs 5 et 6 sont placés de part et d'autre de l'obturateur. Pour plus de clarté ils n'ont pas été accolés à l'obturateur. Le détecteur CCD comporte des détecteurs à transfert de charges tels que CCD 1. Chaque détecteur CCD 1 est juxtaposé à une électrode image 11. On voit donc que l'intensité lumineuse reçue par chaque détecteur CCD 1 est commandé par un obturateur individuel correspondant à une électrode image 11.

L'invention décrite ci-dessus peut également être appliquée comme un compensateur de dynamique optique. Le principe d'une telle compensation est décrit dans le brevet français N° 87 01477, la réalisation étant cependant différente dans le cadre de l'invention.

Le dispositif a pour but de réduire le contraste d'une image avant son acquisition par un détecteur d'image (CCD). Le dispositif doit donc réaliser une fonction de transfert sous-linéaire $I_{transmis}=f(I_{incident})$ la fonction f étant bijective afin de pouvoir restituer à l'image sa dynamique originale par un traitement de l'information réalisant la fonction inverse: $I_{incident}=f^{-1}(I_{transmis})$. Une fonction f particulièrement appropriée peut être: $I_{transmis}=(I_{incident})^k$ où k est compris entre 0,5 et 1.

La réalisation est analogue à celle décrite précédemment avec cependant les variantes suivantes:
- Les directions d'orientations des molécules de cristal liquide sur l'électrode et la contre-électrode peuvent être parallèles. Les deux polariseurs sont alors placés à 45° par rapport à cette direction et ils seront soit parallèles, soit perpendiculaires entre eux.

Dans ce cas, le cristal liquide est utilisé dans un mode de fonctionnement à biréfringence contrôlée électriquement. Dans un tel mode, les variations de contraste du cristal liquide en fonction de la tension sont moins abruptes que dans le cas du nématique en hélice. Ceci évite que la fonction de transfert f soit non-bijective.

Le cristal liquide utilisé peut également être du type smectique chiral utilisé en phase smectique C. Les axes de polarisation des deux polariseurs encadrant l'obturateur sont alors perpendiculaires. Un tel fonctionnement présente l'avantage de fournir une plus grande rapidité de commutation (par exemple de 1 nanoseconde à quelques nanosecondes). De plus, l'angle de basculement dépend de la tension appliquée entre l'électrode de commande 12 et la contre-électrode 21, on obtient ainsi une modulation de l'effet d'anti-éblouissement que l'on désire obtenir.

Afin d'obtenir la sensibilité la plus élevée, il convient d'avoir un rapport de géométrie W/L du photoconducteur le plus grand possible (W = largeur, L = longueur). Pour cela, le photoconducteur peut être disposé de manière à entourer complètement le pixel, comme cela est décrit sur la figure 1. De plus, ceci permet de minimiser le courant sous obscurité du photo-conducteur, puisqu'il n'existe pas de flanc de mésa entre l'électrode d'amenée de courant et le pixel et qu'une partie du courant d'obscurité est due aux flancs de mésas.

La fréquence et la tension d'adressage seront choisies de manière à ce que la tension reportée sur le cristal liquide pour une intensité lumineuse se situant au seuil détectable par le détecteur d'images corresponde à un maximum de la courbe contraste-tension du cristal liquide. La figure 16 représente une courbe typique contraste-tension pour un cristal liquide utilisé en biréfringence à polariseurs croisés. Elle donne le taux d'intensité $I_t$ en fonction de la tension $V_{XL}$ appliqué au cristal liquide. Sur cette courbe sont donc représentées les tensions $V_{XL}$ reportées sur le cristal liquide pour les éclairements minimum (A) et maximum utiles (B), lorsque la tension et la fréquence appliquée à l'ensemble photoconducteur plus cristal liquide a été correctement choisie.

Il est bien évident que la description qui précède n'a été faite qu'à titre d'exemple non limitatif. D'autres variantes peuvent être envisagées sans sortir du cadre de l'invention. Les exemples numériques n'ont été fournis que pour illustrer la description.

## Revendications

1. Obturateur sélectif de lumière comportant une première lame (1) et une deuxième lame transparente (2) enserrant un matériau électrooptique (3), la deuxième lame transparente (2) portant sur sa face (20), en contact avec le matériau électrooptique, au moins une contre-électrode de commande (21), la première lame (1) portant sur sa face (10) en contact avec le matériau électrooptique (3) une pluralité d'électrodes image (11), au moins une électrode de commande (12), des éléments en matériau photoconducteur (13) dont la résistance varie avec l'éclairement qu'il reçoit et permettant de coupler chacune une électrode image (11) à l'électrode de commande (12), les électrode image (11) étant arrangées sous forme matricielle ; caractérisé en ce que chaque élément en matériau photoconducteur (13) encadre une électrode image (11) et est en contact d'une part avec une électrode image (11) et, d'autre part, avec l'électrode de commande (12).

2. Obturateur sélectif selon la revendication 1, caractérisé en ce que les électrodes de commande (12) sont réalisées sous la forme d'un quadrillage d'un matériau conducteur encadrant les différents éléments en matériau photoconducteur (13).

3. Obturateur sélectif selon la revendication 1, caractérisé en ce que la face (20) de la deuxième lame (2) comporte autant de contre-électrodes (21) qu'il y a d'électrodes image (11) et de mêmes dimensions et mêmes formes que les électrodes image, lesdites contre-électrodes étant encadrées par un matériau opaque (22).

4. Obturateur sélectif selon la revendication 1, caractérisé en ce que la face (20) de la deuxième lame (2) comporte sur les zones situées en vis-à-vis des zones de la face (10) de la première lame (1) et non occupées par les électrodes image (11), un matériau opaque à la lumière (22), l'ensemble de ce matériau et la face (20) de la deuxième lame (2) étant recouvert par une contre-électrode (21).

5. Obturateur sélectif selon la revendication 4, caractérisé en ce que le matériau opaque (22) est un métal.

6. Obturateur sélectif selon la revendication 1, caractérisé en ce que les électrodes de commande (12) sont réalisées sur les éléments en matériau photoconducteur (13).

7. Obturateur sélectif selon la revendication 1, caractérisé en ce que les électrodes image (11) et les électrodes de commande (12) sont en contact avec les éléments, matériau photo-conducteur (13) par des couches en matériau semiconducteur dopé (14, 14') facilitant le contact.

8. Obturateur sélectif selon la revendication 1, caractérisé en ce que chaque élément en matériau photoconducteur (13) est en matériau semiconducteur amorphe.

9. Obturateur sélectif selon la revendication 8, caractérisé en ce que le matériau semiconducteur amorphe est du silicium amorphe hydrogéné.

10. Obturateur sélectif selon la revendication 1, caractérisé en ce que le matériau électrooptique (3) est un cristal liquide, la première lame (1) et la deuxième lame (2) comportant chacune une couche d'ancrage en contact avec le matériau électrooptique (3) et adaptée à ce matériau (3).

11. Obturateur sélectif selon la revendication 10, caractérisé en ce qu'il comporte de chaque côté de l'ensemble des lames (1, 2) et du matériau électrooptique, un polariseur (5, 6).

12. Obturateur sélectif selon la revendication 11, caractérisé en ce que le cristal liquide est un cristal du type nématique en hélice et les polariseurs (5, 6) ont leurs directions de polarisation perpendiculaires.

13. Obturateur sélectif selon la revendication 11, caractérisé en ce que le cristal liquide est un cristal du type nématique biréfringent, les polariseurs ayant chacun leur direction de polarisation orientée à 45° par rapport à la direction d'ancrage des molécules sur les faces des lames (1, 2).

14. Obturateur sélectif selon la revendication 11, caractérisé en ce que le cristal liquide est du type smectique chiral à phase smectique C, les polariseurs (5, 6) ayant leurs directions de polarisations croisées.

15. Procédé de réalisation d'un obturateur sélectif selon l'une quelconque des revendications précédentes, comportant les étapes suivantes :
     a) une première étape de dépôt d'une couche de matériau photoconducteur (13) sur une face (10) d'une première lame de substrat (1);

b) une deuxième étape de dépôt d'une couche d'un matériau de contact (14) sur la couche de matériau photoconducteur (13) ;

c) une troisième étape de gravure dans les deux couches déposées précédemment d'éléments photoconducteurs ;

d) une quatrième étape de dépôt d'un matériau conducteur électrique sur l'ensemble précédent ;

e) une cinquième étape de gravure dans ladite couche de matériau conducteur et ladite couche de matériau de contact déposées précédemment d'électrodes image (11) couplées au photoconducteur (13) par la couche de matériau de contact (14') et d'électrodes de contact (12) couplées au photoconducteur (13) par la couche de matériau de contact (14);

f) une sixième étape de réalisation d'au moins une contre-électrode sur une face (20) d'une deuxième lame de substrat (2);

g) une septième étape d'assemblage des deux lames de substrat (1,2) avec entre les deux un matériau électrooptique (3).

16. Procédé selon la revendication 15, caractérisé en ce que la sixième étape comprend d'une phase de réalisation d'éléments opaques aux rayonnements lumineux dans les zones de la face (20) de la deuxième lame de substrat (2) correspondant aux zones de la face (10) de la première lame de substrat (1) non occupées par les électrodes image (11).

17. Détecteur d'images appliquant l'obturateur sélectif selon l'une quelconque des revendications 1 à 14 comprenant un système optique d'entrée et une surface photosensible, caractérisé en ce qu'elle comporte également un obturateur (OR) sélectif selon l'une quelconque des revendications 1 à 14 situé entre le système optique d'entrée (L) et la surface photosensible (DE), les deux lames (1, 2) de l'obturateur étant en matériau transparent ainsi que les électrodes image (11) et les contre-électrodes (21).

18. Détecteur d'images selon la revendication 17, dont la surface sensible d'enregistrement comporte une matrice de photodétecteurs arrangés selon des pas de lignes et des pas de colonnes déterminés, caractérisé en ce que l'obturateur comporte des électrodes image (11) arrangées en matrice dont les pas de lignes et les pas de colonnes sont tels que la projection de chaque électrode image (11) sur la surface sensible coïncide avec un photodétecteur ou avec un multiple entier de photodetecteurs.

19. Détecteur d'images selon la revendication 18, caractérisé en ce que les électrodes images de l'obturateur ont sensiblement les mêmes formes et dimensions que les photodétecteurs et que l'obturateur est accolé à la surface sensible de telle façon qu'à chaque photodétecteur est juxtaposé une électrode image de l'obturateur.

20. Détecteur d'images selon la revendication 17, caractérisé en ce que l'obturateur sélectif est situé dans un autre plan que celui du plan focal du système optique d'entrée.

**Patentansprüche**

1. Selektives Lichtverschlußorgan mit einer ersten Lamelle (1) und einer zweiten, lichtdurchlässigen Lamelle (2), die zwischen sich ein elektro-optisches Material (3) einschließen, wobei die zweite, lichtdurchlässige Lamelle (2) auf ihrer mit dem elektro-optischen Material in Berührung stehenden Seite (20) mindestens eine Steuer-Gegenelektrode (21) trägt, während die erste Lamelle (1) auf ihrer in Berührung mit dem elektro-optischen Material (3) stehenden Seite (10) eine Vielzahl von Bildelektroden (11), mindestens eine Steuerelektrode (12) und Elemente aus Photowiderstandsmaterial (13) trägt, deren Widerstand mit der einfallenden Beleuchtung variiert und die je eine Bildelektrode (11) mit der Steuerelektrode (12) koppeln können, wobei die Bildelektroden (11) in Matrixform angeordnet sind, dadurch gekennzeichnet, daß jedes Element aus Photowiderstandsmaterial (13) eine Bildelektrode (11) umrahmt und einerseits mit einer Bildelektrode (11) und andererseits mit der Steuerelektrode (12) in Berührung steht.

2. Selektives Verschlußorgan nach Anspruch 1, dadurch gekennzeichnet, daß die Steuerelektroden (12) in Quadratrasterform aus einem leitenden Material ausgebildet sind und die verschiedenen Elemente aus Photowiderstandsmaterial (13) umgeben.

3. Selektives Verschlußorgan nach Anspruch 1, dadurch gekennzeichnet, daß die Seite (20) der zweiten Lamelle (2) so viele Gegenelektroden (21) besitzt, wie es Bildelektroden (11) gibt und auch die Abmessungen und Formen denen der Bildelektroden gleichen, wobei die Gegenelektroden von einem lichtundurchlässigen Material (22) umgeben sind.

4. Selektives Verschlußorgan nach Anspruch 1, dadurch gekennzeichnet, daß die Seite (20) der zweiten Lamelle (2) auf den den Zonen der Seite (10) der ersten Lamelle (1) gegenüberliegenden und nicht von den Bildelektroden (11) besetzten Zonen ein lichtundurchlässiges Material (22) besitzt, wobei die Gesamtheit dieses Materials und der Seite (20) der zweiten Lamelle (2) von einer Gegenelektrode (21) bedeckt ist.

5. Selektives Verschlußorgan nach Anspruch 4, dadurch gekennzeichnet, daß das lichtundurchlässige Material (22) ein Metall ist.

6. Selektives Verschlußorgan nach Anspruch 1, dadurch gekennzeichnet, daß die Steuerelektroden (12) auf den Elementen aus Photowiderstandsmaterial (13) realisiert sind.

7. Selektives Verschlußorgan nach Anspruch 1, dadurch gekennzeichnet, daß die Bildelektroden (11) und die Steuerelektroden (12) mit den Elementen aus Photowiderstandsmaterial (13) über Schichten aus dotiertem Halbleitermaterial (14, 14') in Kontakt stehen, die den Kontakt erleichtern.

8. Selektives Verschlußorgan nach Anspruch 1, dadurch gekennzeichnet, daß jedes Element aus Photowiderstandsmaterial (13) aus einem amorphen Halbleitermaterial besteht.

9. Selektives Verschlußorgan nach Anspruch 8, dadurch gekennzeichnet, daß das amorphe Halbleitermaterial amorphes Silizium mit Wasserstoff ist.

10. Selektives Verschlußorgan nach Anspruch 1, dadurch gekennzeichnet, daß das elektro-optische Material (3) ein Flüssigkristall ist und daß die erste Lamelle (1) und die zweite Lamelle (2) je eine Verankerungsschicht in Kontakt mit dem elektro-optischen Material (3) besitzt, die an dieses Material (3) angepaßt ist.

11. Selektives Verschlußorgan nach Anspruch 10, dadurch gekennzeichnet, daß es auf jeder Seite der aus den Lamellen (1, 2) und dem elektro-optischen Material gebildeten Einheit einen Polarisator (5, 6) aufweist.

12. Selektives Verschlußorgan nach Anspruch 11, dadurch gekennzeichnet, daß der Flüssigkristall ein nematischer Spiralkristall ist und daß die Polarisatoren (5, 6) aufeinander senkrecht stehende Polarisationsrichtungen besitzen.

13. Selektives Verschlußorgan nach Anspruch 11, dadurch gekennzeichnet, daß der Flüssigkristall ein Kristall vom doppelbrechenden Nematiktyp ist und daß die Polarisationsrichtungen der Polarisatoren je um 45° gegen die Verankerungsrichtung der Moleküle auf der Seite der Lamellen (1, 2) geneigt sind.

14. Selektives Verschlußorgan nach Anspruch 11, dadurch gekennzeichnet, daß der Flüssigkristall vom chiralen Smectictyp mit smectischer C-Phase ist und daß die Polarisatoren (5, 6) gekreuzte Polarisationsrichtungen besitzen.

15. Verfahren zur Herstellung eines selektives Verschlußorgan nach einem beliebigen der vorhergehenden Ansprüche, das folgende Verfahrensschritte aufweist:

a) in einem ersten Verfahrensschritt das Aufbringen einer Schicht aus Photowiderstandsmaterial (13) auf eine Seite (10) einer ersten Substratlamelle (1),

b) in einem zweiten Verfahrensschritt das Aufbringen einer Schicht eines Kontaktmaterials (14) auf die Schicht aus Photowiderstandsmaterial (13),

c) in einem dritten Schritt das Ätzen von Photowiderstandselementen in diesen beiden vorher aufgebrachten Schichten,

d) in einem vierten Schritt das Aufbringen eines elektrisch leitenden Materials auf die bisher gebildete Struktur,

e) in einem fünften Schritt das Ätzen der Schicht aus leitendem Material und der Schicht aus Kontaktmaterial, die vorher aufgebracht worden sind, zur Ausbildung von Bildelektroden (11), die an den Photowiderstand (13) über die Schicht aus Kontaktmaterial (14') gekoppelt sind und von Kontaktelektroden (12), die an den Photowiderstand (13) über die Schicht aus Kontaktmaterial (14) gekoppelt sind,

f) in einem sechsten Verfahrensschritt die Herstellung mindestens einer Gegenelektrode auf einer Seite (20) einer zweiten Substratlamelle (2),

g) in einem siebten Verfahrensschritt den Zusammenbau der beiden Substratlamellen (1, 2) und das Einfügen eines elektro-optischen Materials (3) zwischen diese.

16. Verfahren nach Anspruch 15, dadurch gekennzeichnet, daß der sechste Verfahrensschritt die Herstellung von für die Lichtstrahlung undurchlässigen Elementen in den Zonen der Seite (20) der zweiten Substratlamelle (2) aufweist, die den Zonen der Seite (10) der ersten Substratlamelle (1) entsprechen, welche nicht von den Bildelektroden (11) besetzt sind.

17. Bilddetektor, der das selektive Verschlußorgan nach einem beliebigen der Ansprüche 1 bis 14 verwendet, mit einem optischen Eingangssystem und einer lichtempfindlichen Oberfläche, dadurch gekennzeichnet, daß er außerdem ein selektives Verschlußorgan (OR) nach einem der Ansprüche 1 bis 14 zwischen den optischen Eingangssystem (L) und der lichtempfindlichen Oberfläche (DE) aufweist, wobei die beiden Lamellen (1, 2) des Verschlußorgans aus einem lichtdurchlässigen Material sind, ebenso wie die Bildelektroden (11) und die Gegenelektroden (21).

18. Bilddetektor nach Anspruch 17, dessen lichtempfindliche Aufzeichnungsoberfläche eine Matrix von Detektoren enthält, die gemäß einem vorbestimmten Zeilenraster und einem vorbestimmten Spaltenraster angeordnet sind, dadurch gekennzeichnet, daß das Verschlußorgan Bildelektroden (11) in einer Matrixanordnung enthält, deren Zeilenraster und Spaltenraster so gewählt sind, daß die Projektion jeder Bildelektrode (11) auf die lichtempfindliche Oberfläche mit einem Photodetektor oder mit einem ganzzahligen Vielfachen von Photodetektoren zusammenfällt.

19. Bilddetektor nach Anspruch 18, dadurch gekennzeichnet, daß die Bildelektroden des Verschlußorgans im wesentlichen dieselben Formen und Abmessungen wie die Photodetektoren besitzen und daß das Verschlußorgan auf die lichtempfindliche Oberfläche so aufgebracht ist, daß jedem Photodetektor eine Bildelektrode des Verschlußorgans benachbart ist.

20. Bilddetektor nach Anspruch 17, dadurch gekennzeichnet, daß das selektive Verschlußorgan in einer anderen Ebene als der Brennebene des optischen Eingangssystems liegt.

## Claims

1. Selective light obturator comprising a first plate (1) and a transparent second plate (2) embracing an electrooptical material (3), the transparent second plate (2) carrying on its face (20), in contact with the electrooptical material, at least one control counterelectrode (21), the first plate (1) carrying on its face (10), in contact with the electrooptical material (3), a plurality of image electrodes (11), at least one control electrode (12), elements composed of photoconductive material (13), the resistance of which varies with the illumination which it receives, and each permitting the coupling of an image electrode (11) to the control electrode (12), the image electrodes (11) being arranged in matrix form; characterised in that each element composed of photoconductive material (13) frames an image electrode (11) and is in contact, on the one hand, with an image electrode (11) and, on the other hand, with the control electrode (12).

2. Selective obturator according to Claim 1, characterised in that the control electrodes (12) are constructed in the form of a grid of a conductive material framing the various elements composed of photoconductive material (13).

3. Selective obturator according to Claim 1, characterised in that the face (20) of the second plate (2) comprises counterelectrodes (21) equal in number to the image electrodes (11) and of the same dimensions and the same shapes as the image electrodes, said counterelectrodes being framed by an opaque material (22).

4. Selective obturator according to Claim 1, characterised in that the face (20) of the second plate (2) comprises on the zones situated opposite the zones of the face (10) of the first plate (1) and not occupied by the image electrodes (11), a material which is opaque to light (22), the whole of this material and the face (20) of the second plate (2) being covered by a counterelectrode (21).

5. Selective obturator according to Claim 4, characterised in that the opaque material (22) is a metal.

6. Selective obturator according to Claim 1, characterised in that the control electrodes (12) are constructed on the elements composed of photoconductive material (13).

7. Selective obturator according to Claim 1, characterised in that the image electrodes (11) and the control electrodes (12) are in contact with the elements, photoconductive material (13) by layers of doped semiconductor material (14, 14') facilitating the contact.

8. Selective obturator according to Claim 1, characterised in that each element composed of photoconductive material (13) is composed of amorphous semiconductor material.

9. Selective obturator according to Claim 8, characterised in that the amorphous semiconductor material is hydrogenated amorphous silicon.

10. Selective obturator according to Claim 1, characterised in that the electrooptical arterial (3) is a liquid crystal, the first plate (1) and the second plate (2) each comprising an anchoring layer in contact with the electrooptical material (3) and fitted to this material (3).

**11.** Selective obturator according to Claim 10, characterised in that it comprises, on each side of the set of the plates (1, 2) and of the electrooptical material, a polariser (5, 6).

**12.** Selective obturator according to Claim 11, characterised in that the liquid crystal is a crystal of the helical nematic type and the polarisers (5, 6) have their polarisation directions perpendicular.

**13.** Selective obturator according to Claim 11, characterised in that the liquid crystal is a crystal of the birefringent nematic type, the polarisers each having their polarisation direction oriented at 45° in relation to the direction of anchoring of the molecules on the faces of the plates (1, 2).

**14.** Selective obturator according to Claim 11, characterised in that the liquid crystal is of the C smectic phase chiral smectic type, the polarisers (5, 6) having their polarisation directions crossed.

**15.** Process for the construction of a selective obturator according to any one of the preceding Claims, comprising the following steps:
a) a first step of depositing a layer of photoconductive material (13) onto a face (10) of a first substrate plate (1);
b) a second step of depositing a layer of a contact material (14) onto the layer of photoconductive material (13);
c) a third step of etching, in the two layers which were deposited previously photoconductive elements;
d) a fourth step of depositing an electrically conductive material onto the preceding assembly;
e) a fifth step of etching, in the said layer of conductive material and the said layer of contact material which were deposited previously, image electrodes (11) coupled to the photoconductor (13) by the layer of contact material (14'), and contact electrodes (12) coupled to the photoconductor (13) by the layer of contact material (14);
f) a sixth step of construction of at least one counterelectrode on a face (20) of a second substrate plate (2);
g) a seventh step of assembling the two substrate plates (1, 2) with, between the two, an electrooptical material (3).

**16.** Process according to Claim 15, characterised in that the sixth step comprises a phase of construction of elements which are opaque to the light radiations in the zones of the face (20) of the second substrate plate (2) corresponding to the zones of the face (10) of the first substrate plate (1) which are not occupied by the image electrodes (11).

**17.** Image detector applying the selective obturator according to any one of Claims 1 to 14, comprising an entrance optical system and a photosensitive surface, characterised in that it further comprises a selective obturator (OR) according to any one of Claims 1 to 14, situated between the entrance optical system (L) and the photosenstive surface (DE), the two plates (1, 2) of the obturator being composed of transparent material in the same manner as the image electrodes (11) and the counterelectrodes (21).

**18.** Image detector according to Claim 17, the sensitive recording surface of which comprises a matrix of photodetectors arranged according to specified row pitches and column pitches, characterised in that the obturator comprises image electrodes (11) arranged in a matrix, the row pitches and column pitches of which are such that the projection of each image electrode (11) on the sensitive surface coincides with a photodetector or with an integer multiple of photodetectors.

**19.** Image detector according to Claim 18, characterised in that the image electrodes of the obturator have substantially the same shapes and dimensions as the photodetectors and in that the obturator is attached to the sensitive surface in such a manner that an image electrode of the obturator is juxtaposed to each photodetector.

**20.** Image detector according to Claim 17, characterised in that the selective obturator is situated in a plane other than that of the focal plane of the entrance optical system.

# FIG.1

# FIG.2
## COUPE a-a

CRISTAL LIQUIDE

# FIG.3

Photoconducteur

( Cristal liquide)

FIG.4

FIG.5

Intensité
transmise

Intensité
incidente

FIG.8

# FIG.6

b

11

13

12

b

# FIG.7
## COUPE b-b

2

21

V

20

3

CRISTAL   LIQUIDE

10

1

11

12

13

## FIG.9

## FIG.10

ITO

## FIG.11

## FIG.12

## FIG.13

CRISTAL LIQUIDE

# FIG.14

# FIG.15

# FIG.16